Europäisches Patentamt

European Patent Office

Office européen des brevets

(11) Publication number: **0 221 512**
**A2**

# (12) EUROPEAN PATENT APPLICATION

(21) Application number: **86115061.3**

(22) Date of filing: **30.10.86**

(51) Int. Cl.⁴: **H01S 3/08**

(30) Priority: **02.11.85 GB 8527047**

(43) Date of publication of application:
**13.05.87 Bulletin 87/20**

(84) Designated Contracting States:
**DE FR IT NL**

(71) Applicant: **ITT INDUSTRIES INC.**
**320 Park Avenue**
**New York, NY 10022(US)**

(72) Inventor: **Plumb, Richard Gordon S.**
**Badgers Green Harlow Common**
**Harlow Essex(GB)**
Inventor: **Smith, David Francis**
**49, Parsonage Leys**
**Harlow Essex(GB)**

(74) Representative: **Morstadt, Volker, Dipl.-Ing. et al**
**c/o Deutsche ITT Industries GmbH**
**Patent/Lizenzabteilung Postfach 840**
**Hans-Bunte-Strasse 19**
**D-7800 Freiburg/Brsg.(DE)**

(54) Injection laser with external reflector.

(57) An external reflector for an injection laser is provided by a flat facet 9 of a semiconductor chip 2 which has been alloyed and then metallised to produce a slightly diffusing reflecting facet which obviates the need for more precise alignment than is conveniently achievable merely by visual line-up.

## INJECTION LASER WITH EXTERNAL REFLECTOR

A number of known injection laser structures call for the use of an external reflector which is required to form one reflecting facet of a second optical cavity in alignment with the optical cavity defined within the body of the semiconductive material of the laser structure. Typically this reflecting facet is provided by a cleaved surface of single crystal semiconductive material. The relatively high quality of specular reflection afforded by such a surface means that adequate alignment of such an external reflector is not normally achievable merely by visual line-up of the chip providing the reflecting facet and the active chip in which population inversion is stimulated, but requires the active chip to be powered while making fine adjustment to the orientation of the external reflector until it is seen to be exercising effective mode control of the laser output. Making provision for fine adjustment of alignment after a coarse adjustment achieved by visual line-up is liable to add significantly to the cost of producing laser structures with external reflectors.

According to the present invention there is provided an injection laser which has an external reflector wherein the reflecting surface of the external reflector is provided by a metallised alloyed plane facet of a semiconductive body.

It is found that by alloying metal into a flat polished or cleaved semiconductor surface, particularly alloying gold into an indium phosphide surface, the originally smooth reflecting surface is broken up into a large number of micro-facets inclined in a range of small angles to the original surface, and that by metallising this structure to enhance its reflectivity, a slightly diffusely reflecting surface is produced which is capable of providing sufficient feedback to function as an effective external reflector when aligned with the active chip solely by visual line-up.

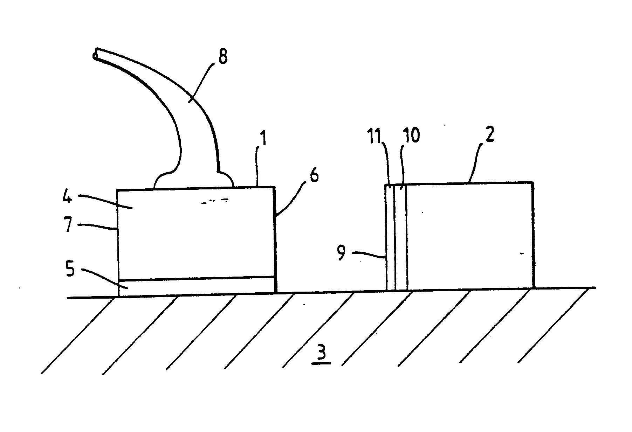

There follows a description of the manufacture of an external reflector for a laser embodying the invention in a preferred form. The description refers to the accompanying drawing which depicts the laser is schematic longitudinal section.

The laser depicted in the drawing consists essentially of two semiconductor chips 1 and 2 mounted upon a common substrate 3.

Semiconductor chip 1 is the active chip of the structure and consists of an indium phosphide substrate 4 supporting epitaxially grown quaternary material 5 designed for operation at a wavelength of 1300nm and possessing the requisite structure for forming the active medium of the laser extending with the axis normal to specularly reflecting cleaved facets 6 and 7. The substrate which is electrically and thermally conductive forms a heat sink for the chip and also one of the electrical contacts. The other electrical contact is provided by a wire band 8.

Semiconductor chip 2 is also made of indium phosphide and its facet 9 facing the active chip forms the external reflector of the laser. This facet 9 is produced by forming an alloyed gold surface layer 10 in a flat polished or cleaved surface and then metallising the resulting surface with a further gold layer 11.

The alloyed layer 10 was formed in conventional manner for forming alloyed contacts. This consisted of evaporating a 98:02 wt% gold:tin standard alloying mixture on to the flat polished surface and then heating it in vacuo until, at a temperature of about 390°C, alloying could be observed to have occurred from the change in appearance of the surface from specularly reflecting to diffuse. A suitable thickness for the evaporated layer before alloying is in the range from 30 to 100nm. Beneath this range the resulting surface tends to be too smooth; while above it the surface tends to be too rough. Typically a thickness of about 70nm is used. After alloying has taken place, and the chip has been allowed to cool, the metallisation layer 11 is provided by the evaporation of a second layer of gold. This is provided in order to increase the reflectivity of the surface now that it has been rendered diffusely reflecting. For this purpose a layer thickness of about 200nm is typically found sufficient.

When a batch of lasers is being manufactured it is normally found convenient to make the chips 2 in batches, in which case one of the flat polished major surfaces of a semiconductor slice (not shown) is provided with the treatment to produce the required plated alloyed surface, and then this slice is diced up to form the individual chips 2.

Such a chip 2 is now in a state suitable for bonding to the heat sink 3 with its facet 9 appropriately oriented with respect to facet 6 or chip 1. This orientation being achievable with a sufficient degree of precision for the external mirror to exercise effective mode control soley by visual line-up. The absolute magnitude of the separation of these facets is not normally critical since the internal and external laser cavities will have different coefficients of thermal expansion, and any separation will give a single longitudinal mode output if the temperature is raised or lowered a few degrees.

## Claims

1. An injection laser which has an external reflector providing slightly non-specular reflection such as to render alignment with the laser less critical.

2. An injection laser which has an external reflector wherein the reflecting surface of the external reflector is provided by a metallised alloyed plane facet (9) of a semiconductive body (2).

3. An injection laser as claimed in claim 2 wherein said semiconductive body (2) is made of indium phosphide or gallium arsenide.

4. An injection laser as claimed in claim 2 or 3 wherein said plane facet (9) is alloyed with gold.

5. An injection laser substantially as hereinbefore described with reference to the accompanying drawing.